(19) Europäisches Patentamt
European Patent Office
Office européen des brevets

(11) EP 2 400 538 A1

(12) EUROPEAN PATENT APPLICATION

(43) Date of publication:
28.12.2011 Bulletin 2011/52

(51) Int Cl.:
H01L 21/762 (2006.01)     H01L 23/36 (2006.01)

(21) Application number: 10251126.8

(22) Date of filing: 22.06.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(71) Applicant: NXP B.V.
5656 AG Eindhoven (NL)

(72) Inventors:
• Golubovic, Dusan
Redhill, Surrey RH1 1DL (GB)

• Doornbos, Gerben
Redhill, Surrey RH1 1DL (GB)

(74) Representative: Burton, Nick et al
NXP Semiconductors
IP&L Department
Betchworth House
57-65 Station Road
Redhill, Surrey RH1 1DL (GB)

(54) **A silicon on insulator structure**

(57)     A silicon on insulator structure (700; 800) comprising a first silicon layer (706), an insulator layer (708), and a second silicon layer (710). The structure further comprises a semiconductor device (702) provided by the first silicon layer (706); and a heat transfer element (704; 822) passing through the insulator layer (708) and configured to transfer heat from the semiconductor device (702) to the second silicon layer (710) through the insulator (708). The heat transfer element (704; 822) is doped such that it provides a diode in reverse bias from the semiconductor device (702) to the second silicon layer (710).

## Figure 7

EP 2 400 538 A1

**Description**

The present disclosure relates to the field of silicon on insulator structures, and particularly, although not exclusively, silicon on insulator structures that include a heat transfer element to transfer heat from a semiconductor device on a first silicon layer to the second silicon layer through the insulator.

It is known to use heat sink components with semiconductor devices on silicon insulator structures. Such known heat sinks include external heat sinks that are mounted on a printed circuit board (PCB) such that they can transfer heat away from the semiconductor device.

The listing or discussion of a prior-published document or any background in the specification should not necessarily be taken as an acknowledgement that the document or background is part of the state of the art or is common general knowledge.

According to a first aspect of the invention, there is provided a silicon on insulator structure comprising a first silicon layer, an insulator layer, and a second silicon layer, the structure further comprising:

a semiconductor device provided by the first silicon layer;
a heat transfer element passing through the insulator layer and configured to transfer heat from the semiconductor device to the second silicon layer through the insulator; and

wherein the heat transfer element is doped such that it provides a diode in reverse bias from the semiconductor device to the second silicon layer.

Such a structure can provide improved heat transfer away from the semiconductor device, without significantly electrically coupling the semiconductor device to the second silicon layer. The heat transfer element can provide a thermally conductive path passed the insulator layer, which may not be a good thermal conductor in addition to being an electrical insulator. The structure can enable the silicon area (or real-estate) that is required for a device, such as a high voltage field effect transistor (FET), to be reduced when compared with the prior art. This can enable more devices to be provided on an integrated circuit.

In addition, higher voltage signals, or high voltage signals for longer periods of time, can be used without thermal degradation as heat can be removed more efficiently and quickly. Therefore, a structure according to embodiments of the invention can be used for a wider range of applications than is possible with the prior art.

The first silicon layer may comprise one or more isolation regions configured to laterally isolate the semiconductor device from other semiconductor devices. The heat transfer element may be located between an isolation region and the semiconductor device. This can be in contrast to the prior art, where a contact-to-handle wafer (CHW) is located within an isolation region/trench such that the handle wafer can be biased at a fixed potential (ground) and prevent floating body effects from affecting the performance of the device. Providing the heat transfer element between the isolation region and the semiconductor device can enable semiconductor devices to be located more closely together, and also reduce the distance between the heat generating semiconductor device and the heat transfer element for removing the heat from the semiconductor device.

The semiconductor device may be a high voltage device, and the heat transfer element may be located in a high voltage region of the semiconductor device. This may not be achievable by the prior art, as locating the heat transfer element in the high voltage region would also provide an electrically conductive link away from the semiconductor device such that it would not function correctly. This is avoided by embodiments of the present invention as the heat transfer element provides a diode in reverse bias such that no significant current can flow away from the semiconductor device through the heat transfer element.

The heat transfer element may comprise a contact-to-handle wafer (CHW). The contact-to handle wafer may be n-doped if an associated semiconductor device terminal is p-doped, and may be p-doped if an associated semiconductor device terminal is n-doped. The contact-to handle wafer may be doped in the opposite way to an associated semiconductor device terminal. This can provide the required doping profile for the heat transfer element to provide a reverse biased diode.

The associated semiconductor device terminal may be adjacent to the heat transfer element, or substantially adjacent to, or in close proximity to the heat transfer element. A maximum distance between the semiconductor device and the heat transfer element may be determined by the equation: $L_{max} = 100 \cdot t_{BOX} \cdot A_{CHW}/A_{dev}$ [μm]; where $T_{BOX}$ is the actual thickness of a buried oxide, $A_{CHW}$ is the cross-section area of the heat transfer element and $A_{dev}$ is the footprint area of the device. As a non-limiting example, the maximum distance between the semiconductor device and heat transfer element such that they are in close proximity to each other may be of the order of (x,y) tens of micrometres, although it will be appreciated that the feature "in close proximity to" should be considered as appropriate for specific device dimensions.

The associated semiconductor device terminal may comprise an additional edge region that surrounds the heat transfer element. It will be appreciated that the additional edge region and heat transfer element should be doped in accordance with a type of the semiconductor device in order to provide a reverse biased diode. The additional edge region may be doped in the same way as a source of the semiconductor device, and the contact-to-handle wafer may be doped in the opposite way.

The associated semiconductor device terminal may comprise the source of a field effect transistor. The additional edge region may be an extension of the source of the field effect transistor, and it may be doped in the same way as the source of the field effect transistor.

The structure may comprise two heat transfer elements. The heat transfer elements may be provided at opposite ends of the associated semiconductor device terminal.

There may be provided an integrated circuit comprising any structure disclosed herein.

A description is now given, by way of example only, with reference to the accompanying drawings, in which:

Figure 1 illustrates graphically the performance of high voltage devices;
Figure 2 illustrates a prior art semiconductor device;
Figures 3a and 3b illustrate a prior art contact-to-handle wafer;
Figure 4 illustrates a two-dimensional simulation of a temperature profile in a semiconductor device;
Figure 5 illustrates graphically the maximum temperature in a prior art high voltage device;
Figure 6 illustrates a structure according to an embodiment of the invention;
Figure 7 illustrates a structure according to another embodiment of the invention;
and
Figures 8 and 9 illustrate alternative views of a structure according to another embodiment of the invention.

One or more embodiments disclosed herein relate to a silicon on insulator structure having a heat transfer element such as a contact-to-handle (CHW) wafer, whereby the heat transfer element can transfer heat from a semiconductor device on the first silicon layer to a second silicon layer through an insulator layer. The heat transfer element can be doped such that it provides a diode in reverse bias from the semiconductor device to the second silicon layer. Such a heat transfer element can be located relatively close to the semiconductor device as it does not cause a significant current to flow from the semiconductor device to the second silicon layer, which would otherwise cause the semiconductor device to not operate as required. The heat transfer element may pass a leakage current from the semiconductor device to the second silicon layer, and the heat transfer element can be designed and located such that the expected leakage current enables the semiconductor device to operate as required.

It is known to use silicon on insulator (SOI) wafers for integrated circuits (ICs), and one example of an integrated high-voltage (HV) technology is NXP's proprietary Advanced Bipolar- CMOS-DMOS (ABCD) technology. High(er) voltage EZ-HV™ SOI processes with switches specified for -650 V are also known. Due to a high thermal resistance of the underlying insulator layer, which in these examples can be a buried silicon oxide layer (which may be referred to as BOX), the heat transfer that is achievable from a device on the silicon is less than is achievable with standard bulk-silicon wafers where heat transfer can occur throughout the wafer's volume. In addition, high voltage devices in both ABCD and EZ-HV technologies are surrounded by their own isolation which prevents lateral dissipation of heat. Medium-trench-isolation (MTI) is used in ABCD technology, and Locos based isolation (ID) is used in EZ-HV.

In light of the above, heat is mainly dissipated through the metallization which makes high voltage (HV) devices on SOI wafers more prone to heating effects and more likely to enter a thermal breakdown region. Thermal breakdown sets in when junction temperature rises above the intrinsic silicon temperature and thermal generation of electrons/holes becomes significant and affects the conductivity of the silicon, thereby turning it into an intrinsic (effectively undoped) material.

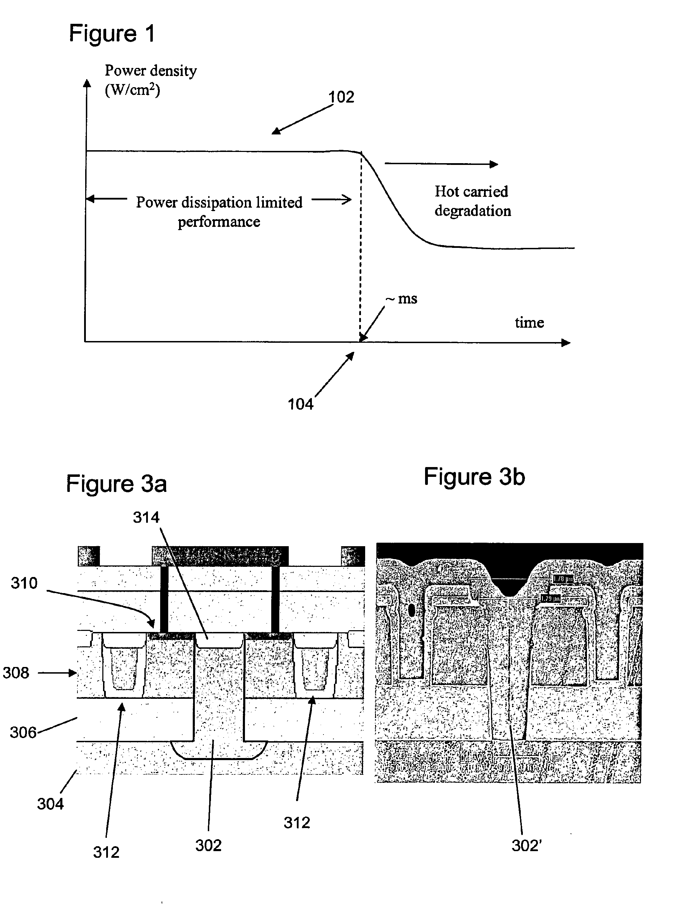

Thermal breakdown can determine the safe operating area (SOA) of high-voltage devices and limit voltage signals to approximately 10 ms wide signal pulses. Figure 1 illustrates graphically the power density versus a pulse width in a generic high-voltage device. The approximately flat part 102 of the graph is determined by power dissipation, and it can be seen that as the pulse width increases above a value that is of the order of magnitude of milliseconds there is hot carried degradation. The value of the pulse width at which degradation occurs is shown as reference 104 in Figure 1. This limit on the pulse width that can be used with HV devices can be considered as a significant disadvantage for many applications.

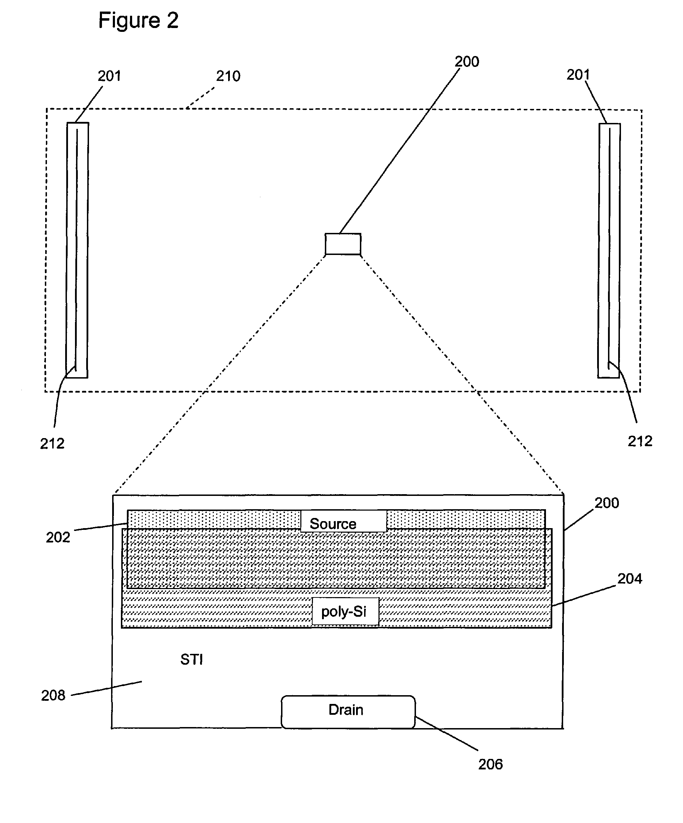

Figure 2 illustrates schematically an aerial view of a prior art high voltage semiconductor device 200 on a silicon on insulator (SOI) wafer 210. It will be appreciated that the region of SOI wafer 210 that is shown in Figure 2 is only a portion of the wafer 210, which in practice extends at least to the right and the left in order for further semiconductor devices to be provided. Also shown in Figure 2 are two isolation regions 201 that are provided to prevent lateral dissipation of heat between semiconductor devices as indicated above. These isolation regions 201 include a contact-to-handle wafer (CHW or CH) 212 to transfer heat away from the device 200, as will be described in more detail with reference to Figures 3a and 3b. The bottom of Figure 2 shows the semiconductor device 200 in more detail.

It will be appreciated that there is a relatively large distance between the device 200 and the contact-to-handle wafers in the isolation regions 201, and this can mean that heat cannot be removed from the device 200 efficiently.

The semiconductor device 200 in this example is a field effect transistor (FET), and the source 202 and drain 206 are shown in Figure 2. Also shown in Figure 2 are the poly-silicon region 204 and the shallow trench isolation (STI) region 208.

Figure 3a illustrates a cross-sectional view of an isolation trench having a contact-to-handle wafer (CHW) 302 in the known ABCD9 technology. The CHW is made of poly-silicon, that is doped in-situ or after the deposition. The view of Figure 3a represents a cross-sectional view through an isolation trench 201 of Figure 2. The CHW 302 provides a connection between the silicon on oxide 308 and the silicon handle wafer 304 underneath the buried silicon oxide layer (BOX) 306. The provision of such a CHW requires an additional photolithography mask.

It is ensured that the handle wafer 304 is biased at a fixed potential (ground) so that no floating body effects can affect the device performance. A cross-sectional view of the CHW 302' of Figure 3a taken with a scanning electrode microscope (SEM) is shown as Figure 3b.

The CHW 302 that is used in the ABCD9 technology is made from highly n-doped polycrystalline silicon. Highly doped polycrystalline silicon is a good electrical and heat conductor with a thermal conductivity of around 100 W/mK for both n- and p-doped polycrystalline Si (note that copper has a thermal conductivity of around 400 W/mK at room temperature). In the known ABCD9 technology, the contact-to-handle-wafer (CHW) 302 is always enclosed in the device HV isolation (MTI), that is between two medium isolation trenches 312. In addition, the CHW 302 is placed outside HV areas as it is always biased at ground level, and therefore its presence inside the HV area would cause a current flow through the CHW 302, which would cause the device to operate incorrectly.

Between each side of the CHW 302 and the isolation trenches 312 is a region 310 that provides an electrical contact to the CHW 302. The CHW 302 also has an isolation cap 314 to prevent direct contact with the CHW 302.

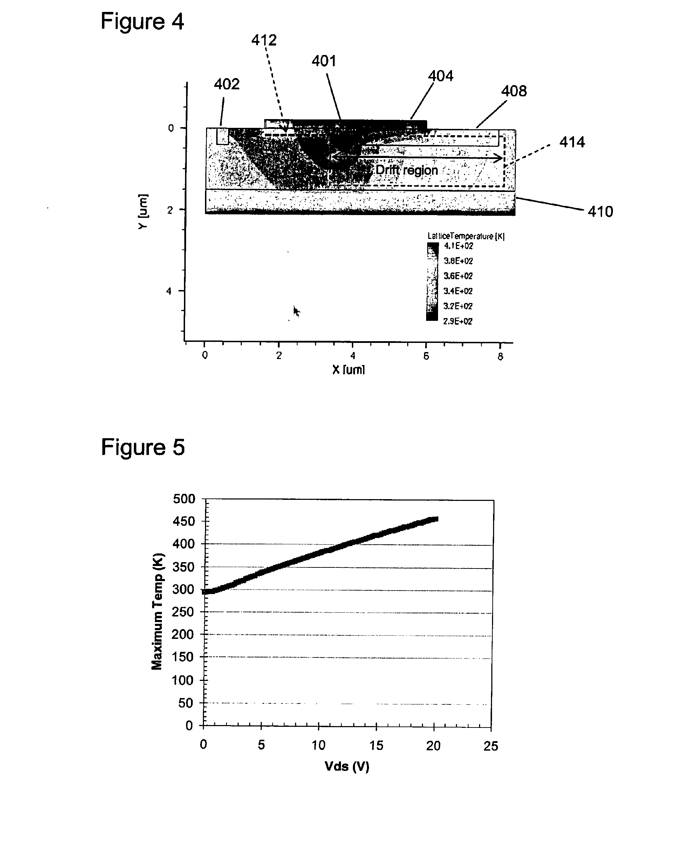

Figure 4 shows a two-dimensional simulated temperature profile in a 60V nMOSt device under static conditions. Shown in Figure 4 are the source 402, the poly-silicon region 404, the STI region 408, and the handle wafer 410. Figure 5 shows the increase of the device temperature as the drain voltage increases. The gate bias is 3.3 V in both Figure 4 and Figure 5, and the device's drain is at 60 V for the simulation of Figure 4.

It can be seen from Figure 4 that the highest temperature corresponds to the current crowding point, this is the region with reference 401 in Figure 4 where the current crosses from the inversion layer 412 to the drift region 414. It will be appreciated that the inversion layer 412 is actually located at the surface of the silicon, but is plotted below the surface of the silicon in Figure 5 for ease of illustration.

It can be seen from Figure 5 that under static conditions the temperature can easily exceed 450K with only a 20 V drain bias.

It has been found that current ABCD device architectures can be modified to provide a layout of HV devices with an integrated heat sink. The term "integrated" may be construed as providing the heat sink within the lateral isolation regions such that it is in the same high voltage region as the semiconductor device and/or manufactured with the same photolithographic mask that is used to manufacture the semiconductor device. The heat sink may need to provide electrical isolation between the semiconductor device and the handle-wafer such that no current flows through the heat sink to the handle-wafer, and this can enable the handle wafer to be biased to the ground level.

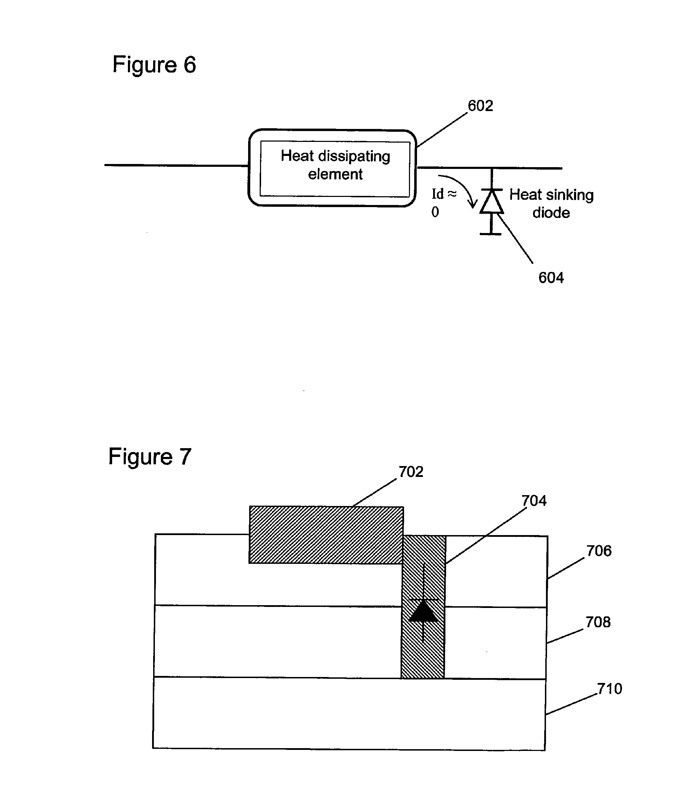

Figure 6 illustrates an embodiment of the invention, whereby a heat sinking diode 604 (which is an example of a heat transfer element) is configured to transfer heat away from a heat dissipating element 602. The heat dissipating element 602 can be any active or passive device. The heat sinking diode 604 can transfer heat away from the heat dissipating element 602, yet is in reverse bias when considered in a direction away from the heat dissipating element 602 such that significant current does not flow through the heat sinking diode 604. The anode of the heat sinking diode 604 is nearest the heat dissipating element 602 such that it does not significantly conduct charge away from the heat dissipating component 602, and therefore does not significantly affect the performance of the heat dissipating component 602.

It will be appreciated that the heat sinking diode 604 will have a leakage current in reverse bias, and the heat sinking diode can be designed in accordance with leakage current requirements for specific applications.

Figure 7 illustrates a cross-sectional view of a silicon on insulator (SOI) structure 700 according to an embodiment of the invention. The SOI structure 700 comprises a first silicon layer 706, a second silicon layer 710, and an insulator layer 708 between the two silicon layers 706, 710. The insulator layer 708 may be a silicon oxide layer, a layer of silicon nitride, silicon carbide, glass, sapphire, or any other material that can be used in this field of technology.

A semiconductor device 702 is provided on the first silicon layer 706, and in one example is a field effect transistor (FET) of a high voltage device. However, it will be appreciated that the invention is not limited to a specific type of semiconductor device 702, and in other embodiments, the semiconductor device could be a bipolar junction transistor (BJT) LDMOS, DDMOS, DIMOS, or IGBT as non-limiting examples. It will also be appreciated that the invention is not limited to high voltage devices.

Thermally coupled to the semiconductor device 702 is a heat transfer element 704 that passes through the insulator layer 708, and can transfer heat from the semiconductor device 702 to the second silicon layer 710. As identified above, the poor thermal conduction properties of the electrically isolative layer 708 can make it otherwise difficult to remove heat from the semiconductor device 702.

The heat transfer element 704 comprises a material that is doped such that it provides a diode in reverse bias from the semiconductor device 702 to the second silicon layer 710. The heat transfer element may be made from doped silicon or poly-silicon such that it provides a p-n or n-p junction between the semiconductor device 702 and the second silicon layer 710. It will be appreciated that either a p-n or n-p junction will be required to provide a diode in reverse bias depending upon the type of the semiconductor device 702.

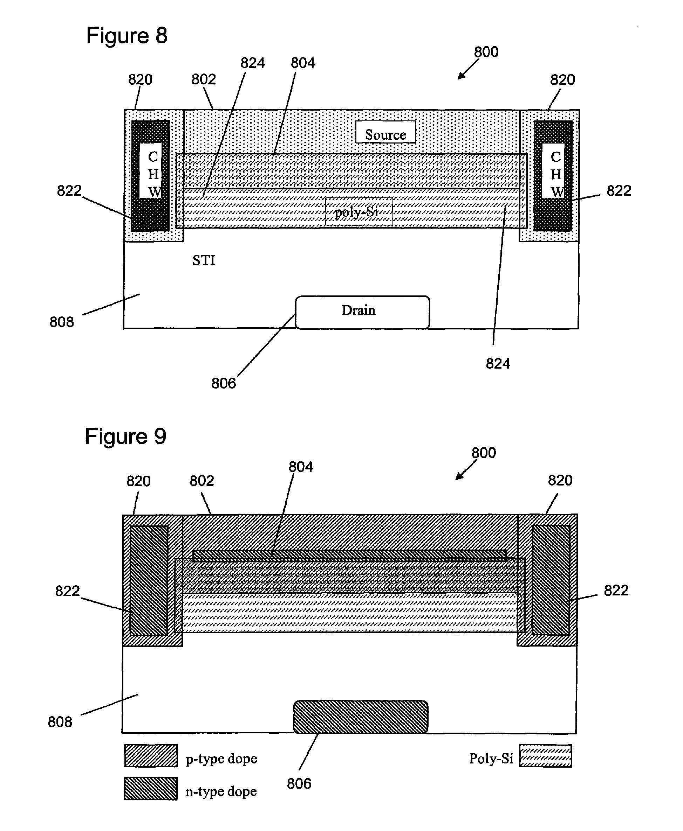

Figure 8 illustrates an aerial view of an SOI structure 800 according to an embodiment of the invention. Figure 9 illustrates an aerial view of the same SOI structure as Figure 8, and graphically illustrates the doping profile of the structure for an nMOSt device. The structure 800 may be considered as an edge terminated HV device with integrated heat sink. Features of Figure 8 that are common to Figure 2 are provided with similar reference numbers in the 800 series and are not necessarily described in detail again here.

Compared to a standard edge-terminated device (as shown in Figure 2), the "low potential" source area 802 is extended laterally by additional edge regions 820. The additional edge regions 820 are doped in the same way as the source 802 as shown in Figure 9. Located within each of the additional edge regions 820 is a contact-to-handle wafer (CHW) heat transfer element 822. A CHW 822 is located within an additional edge region 820 inasmuch as it is surrounded by the additional edge regions 820 when viewed from above. The CHW's 822 are doped in the opposite way to the additional edge regions 820. That is, if the additional edge regions 820 are p-type doped then the CHW's are n-type doped, and if the additional edge regions 820 are n-type doped then the CHW's are p-type doped.

Due to the above doping profile, and as shown in Figure 9, reverse biased diodes are formed by the additional edge regions 820 (which can be considered as extensions of the source) and the CHW's 822. Also, the drain 806 (which may be referred to as an extended drain) is n-doped and is at a positive potential with respect to the ground during normal operation. Therefore, a reverse biased pn-diode is also provided between the extended drain 806 and p-type source extension 802 surrounding the CHW contact 822, which is also at the ground during the normal operation. The CHW contact 822 can be kept at ground so that the leakage current between the CHW 822 and its p-type surroundings 820 is as low as possible.

The shorter the distance between the edge of the CHW contact 822 (and its p-type surroundings 820) and the drain contact 806, the more reverse the extended drain/p-type junction is, and therefore the higher the leakage current. In some examples, the length and position of CHW heat-sinks 822, and their proximity to the drain 806, may be important parameters to consider so as to reduce/minimize the reverse bias of the diode formed between the drain 806 and ensure that any leakage current is acceptable.

As shown in Figure 8, the CHW heat transfer element 822 is adjacent to the source terminal 802 of the semiconductor device. In other embodiments, the CHW heat transfer element 822 may be substantially adjacent to the semiconductor device, or in close proximity to the semiconductor device. That is, the CHW heat transfer element 822 may be close enough to the semiconductor device to be capable of transferring heat away from the semiconductor without necessarily being in contact with the semiconductor device or a terminal of the semiconductor device.

Based on a thermal conductivity of silicon oxide being 100 times lower than silicon, an approximation of the maximum distance from the hottest part of the device to the CHW can be determined as:

$$L_{max} = 100 \cdot t_{BOX} \cdot A_{CHW}/A_{dev} \ [\mu m],$$

where $t_{BOX}$ is the actual thickness of the buried oxide, $A_{CHW}$ is the cross-section area of the CHW heat sink and $A_{dev}$ is the footprint area of the device.

In this way, it will be appreciated that a required proximity of a CHW heat sink to a semiconductor device can be dependent upon specific parameters/characteristics of the semiconductor device and CHW heat sink in question.

Embodiments disclosed herein can be considered as making use of a highly-doped CHW contact as a wafer integrated heat sink for high-voltage devices.

Advantages associated with embodiments of the invention include:

- Incorporation of heat-sink elements can be carried out without any modifications to the original technology process. According to some embodiments of the invention, no additional photolithography masks may be required to provide the heat transfer element and this can provide advantages in terms of ease of manufacture. Depending upon the device architecture, additional photolithography masks may be required in other embodiments.
- Introduction of the heat-sink elements may not require fundamental modification of the device layout; the new junctions introduced to prevent/reduce any current leakage through the CHW heat-sinks in the device area may need to be analyzed/optimized further.

- The solution proposed by embodiments disclosed herein can be considered as general, and not limited to NXP's high-voltage processes such as ABCD or EZ-HV processes.
- Highly doped poly-silicon CHW heat sinks have been found to be capable of removing sufficient heat over the entire area of the active silicon over the buried oxide insulator layer. In the case of ABCD9, the active silicon is 1.5 $\mu$m thick. Therefore, a CHW heat-sink is expected to be very efficient in removing heat from the devices. It has been found that although metals have a heat conductivity that is two to three times higher than poly-silicon, poly-silicon may be capable of transferring sufficient heat away from the semiconductor device. It can be advantageous to avoid the use of metals for ease of manufacture and mechanical properties such as stress, and therefore use of a poly-silicon heat transfer element can be seen as advantageous.
- The CHW heat-sink can be positioned very close to the actual source of heat-generation, which can further improve the efficiency of heat removal when compared with known metallization heat-sinks.
- A reduction in the amount of silicon area required to provide a suitably isolated semiconductor device with sufficient heat removal properties can be significant. The improvements in the area of a HV transistor aimed at high-power operation may be particularly significant, as currently the devices in the high-power regime occupy about three-times more area than similar transistors that do not operate in the high-power regime.

One or more embodiments of the present invention can be provided by integrated circuits (ICs) that may comprise class D amplifiers. ICs according to embodiments of the invention can provide relay drivers or audio amplifiers, as non-limiting examples.

**Claims**

1. A silicon on insulator structure (700; 800) comprising a first silicon layer (706), an insulator layer (708), and a second silicon layer (710), the structure (700; 800) further comprising:

   a semiconductor device (702) provided by the first silicon layer (706);
   a heat transfer element (704; 822) passing through the insulator layer (708) and configured to transfer heat from the semiconductor device (702) to the second silicon layer (710) through the insulator (708); and
   wherein the heat transfer element (704; 822) is doped such that it provides a diode in reverse bias from the semiconductor device (702) to the second silicon layer (710).

2. The structure of claim 1, wherein the first silicon layer (706) comprises one or more isolation regions configured to laterally isolate the semiconductor device (702) from other semiconductor devices, and wherein the heat transfer element (704; 822) is located between an isolation region and the semiconductor device (702).

3. The structure of claim 1 or claim 2, wherein the semiconductor device (702) is a high voltage device, and wherein the heat transfer element (704; 822) is located in a high voltage region of the semiconductor device (702).

4. The structure of any one of claims 1 to 3, wherein the heat transfer element (704; 822) comprises a contact-to-handle wafer.

5. The structure of claim 4, wherein the contact-to handle wafer is n-doped if an associated semiconductor device terminal (802) is p-doped, and is p-doped if an associated semiconductor device terminal (802) is n-doped.

6. The structure of claim 5, wherein an associated semiconductor device terminal (802) comprises an additional edge region (820) that surrounds the heat transfer element (822).

7. The structure of claim 5 or claim 6, wherein the associated semiconductor device terminal (802) comprises the source of a field effect transistor.

8. The structure of claim 7, wherein the additional edge region (820) is an extension of the source (802) of the field effect transistor.

9. The structure of any one of claims 5 to 8, comprising two heat transfer elements (822), the heat transfer elements (822) being provided at opposite ends of the associated semiconductor device terminal (802).

10. An integrated circuit comprising the structure of any preceding claim.

## Figure 1

Power density
(W/cm²)

102

Power dissipation limited
performance

Hot carried
degradation

~ ms

time

104

## Figure 3a

314

310

308

306

304

312

302

312

## Figure 3b

302'

# Figure 2

## Figure 4

## Figure 5

## Figure 6

602

Heat dissipating
element

Id ≈
0

Heat sinking
diode

604

## Figure 7

702

704

706

708

710

## Figure 8

820  802  824  804  800  820

822

| C H W | | C H W |

Source

poly-Si

STI

Drain

808  806  824  822

## Figure 9

820  802  804  800  820

822  822

808

806

| p-type dope | | Poly-Si | |
| n-type dope | | | |

**Europäisches Patentamt**
**European Patent Office**
**Office européen des brevets**

# EUROPEAN SEARCH REPORT

Application Number

EP 10 25 1126

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/093062 A1 (TIHANYI JENOE [DE]) 5 May 2005 (2005-05-05) | 1,3-6,10 | INV. H01L21/762 H01L23/36 |
| A | * page 2, paragraph 30 - page 4, paragraph 48; figure 1a * | 2,7-9 | |
| X | US 6 121 661 A (ASSADERAGHI FARIBORZ [US] ET AL) 19 September 2000 (2000-09-19) | 1-4,10 | |
| A | * column 3, line 3 - column 6, line 4; figure 4A * | 5-9 | |
| X | US 2008/224257 A1 (MORI YASUHIRO [JP]) 18 September 2008 (2008-09-18) | 1,3,4,10 | |
| A | * page 1, paragraph 3 - page 4, paragraph 53; figure 6; example 3 * | 2,5-9 | |
| X | JP 11 354807 A (NISSAN MOTOR) 24 December 1999 (1999-12-24) | 1-4,10 | |
| A | * page 4, paragraph 28 - page 7, paragraph 51; figure 1 * | 5-9 | |
| X | US 2004/104452 A1 (YAMAGUCHI YASUO [JP]) 3 June 2004 (2004-06-03) | 1,4,10 | TECHNICAL FIELDS SEARCHED (IPC) |
| A | * page 1, paragraph 5 - page 10, paragraph 127; figures 1,3 * | 2,3,5-9 | H01L |

The present search report has been drawn up for all claims

| Place of search | Date of completion of the search | Examiner |
|---|---|---|
| The Hague | 11 November 2010 | Lyons, Christopher |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 25 1126

This annex lists the patent family members relating to the patent documents cited in the above-mentioned European search report.
The members are as contained in the European Patent Office EDP file on
The European Patent Office is in no way liable for these particulars which are merely given for the purpose of information.

11-11-2010

| Patent document cited in search report | | Publication date | Patent family member(s) | | Publication date |
|---|---|---|---|---|---|
| US 2005093062 | A1 | 05-05-2005 | DE 10343503 | B3 | 02-02-2006 |
| US 6121661 | A | 19-09-2000 | US 6352882 | B1 | 05-03-2002 |
| US 2008224257 | A1 | 18-09-2008 | NONE | | |
| JP 11354807 | A | 24-12-1999 | NONE | | |
| US 2004104452 | A1 | 03-06-2004 | NONE | | |